# EUROPEAN PATENT APPLICATION

(11) **EP 2 261 976 A1**
(43) Date of publication of application: **15.12.2010**
(21) Application number: 09162623.4
(22) Date of filing: 12.06.2009
(51) Int. Cl.: H01L 27/142

(54) **Semiconductor device module, method of manufacturing a semiconductor device module, semiconductor device module manufacturing device**

(71) Applicant: Applied Materials, Inc., Santa Clara, CA 95054 (US)
(72) Inventor: Repmann, Tobias, 63755, Alzenau (DE); Straub, Axel, 55218, Ingelheim (DE)
(74) Representative: Zimmermann & Partner

(57) **Abstract**

A semiconductor device module is provided, including a number of n semiconductor devices formed on a substrate (10), n being an integer ≥ 2; each semiconductor device having a stack of a first contact layer region (12; 22), a semiconductor layer region (30), and a second contact layer region (40); wherein the first contact layer region of each (n-1)th semiconductor device is connected to the second contact layer region of the nth semiconductor device by an interconnection (46); and wherein, of the first and second contact layer regions, at least the first contact layer region of at least one of the semiconductor devices has a varying thickness, the thickness being maximum at the interconnection.

## Description

### FIELD OF THE INVENTION

Embodiments of the invention relate to semiconductor device modules, for instance to solar cell modules. They relate particularly to a semiconductor device module, a method of manufacturing a semiconductor device module, and a semiconductor device module manufacturing device.

### BACKGROUND OF THE INVENTION

Semiconductor devices have many functions in a plurality of industrial fields, including, but not limited to, fabrication of electronic devices, such as transistors, and photovoltaic cells, such as solar cells. Individual photovoltaic cells are e.g. used for powering small devices such as electronic calculators. Photovoltaic arrays are used for instance in remote area power systems, earth-orbiting satellites and space probes, remote radiotelephones and water pumping applications.

The principle of operation of a solar cell containing a p-n junction can be roughly described as follows. The solar cell absorbs light and generates electron/hole charge pairs due to absorbed light energy. The electrons move toward the n-layer side of the junction, and the holes move toward the p-layer side due to drift caused by the junction electric field and diffusion.

For solar cell production, so called bulk technologies or thin-film technologies may be applied, the former utilizing bulk semiconductor wafers, the latter resulting in thin-film solar cells. Thin-film solar cell modules can be produced using a substrate technology or a superstrate technology. Typically, a Silicon thin-film solar cell may have a p-i-n cell structure predominantly operating as a drift controlled solar cell device. Silicon thin-film modules on glass may be from the superstrate type in which the active layers are deposited e.g. on a glass/TCO (transparent conductive oxide) substrate, in particular on a glass substrate covered with a TCO layer. The glass/TCO substrate is produced as uniform as possible. The requirements to the TCO in this case are transparency, conductivity and light scattering.

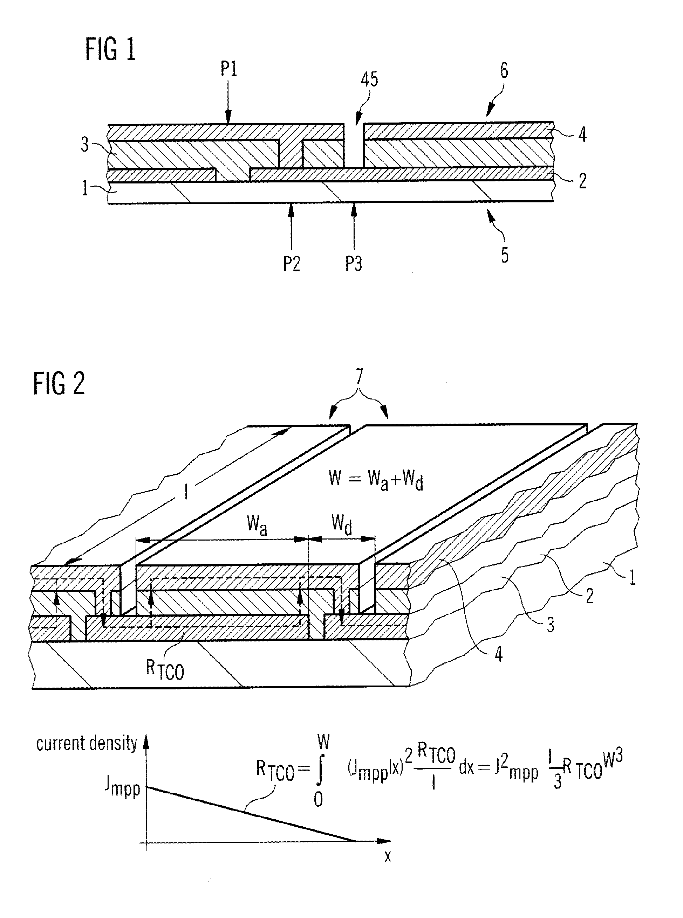

The interconnection scheme of a thin-film solar cell module, such as indicated in Fig. 1, is typically formed by three separate laser steps. For instance, for forming a typical superstrate thin-film solar cell module, laser steps P1 to P3 are performed. In the first laser step, a front contact 2, in the present example a TCO layer, which is formed on a glass plate 1, is patterned with a laser beam P1, e.g. from a back contact side 6 of the coated glass plate or the final solar cell module, respectively. Thereby, the front contacts 2 are isolated. Subsequently, an active silicon layer 3, e.g. a-Si, a-Si/µc-Si-tandem stack, is deposited and again patterned with a laser beam P2 in the second laser step, e.g. from the front contact side 5 of the coated glass plate or the final solar cell module, respectively. Thereby, the active silicon layer is opened for a subsequent interconnection of neighboring solar cells. Then, a further layer or layer stack, e.g. including TCO and/or metal layers, is deposited as a so-called back contact 4 and fills the P2 pattern. This results in the interconnection of the back contact of a solar cell to the front contact of a neighboring solar cell. Finally, the back contact is patterned together with the active layer 3 in the third laser step using laser beam P3, thereby forming the isolation groove 45, e.g. from the front contact side 5. Thereby, the back contacts are isolated. Such a process results in a plurality of solar cells deposited on the glass plate and serially connected to each other. In typical examples of forming an interconnection scheme of a thin-film solar cell module from the superstrate type, the P1 to P3 patterning steps may be performed by laser irradiation through the glass plate 1 from the front contact side 5.

A solar cell typically consists of the following layers or layer stacks: front contact, silicon solar cell and back contact. To minimize Ohmic losses, these layers or layer stacks are cut into cell stripes, which are series-connected by alternating deposition and patterning, resulting in a solar cell module. Typically, the patterning is done for instance by above mentioned three-step process: isolation of front contact (P1), opening Silicon layer to form interconnection groove of cell n and cell n+1 (P2), and isolation of back contact (P3). In a typical solar cell or solar cell module, respectively, Ohmic losses are created in the contacts. For instance, in a superstrate solar cell module, the main Ohmic loss is produced in the front contacts. Further, the current density within the front contacts in a direction perpendicular to the cell stripes is varying. The Ohmic losses in the front contacts are highest at highest current density and lowest at lowest current density. Moreover, an increased thickness of the front contacts may promote optical transmission losses, also referred to herein as transmission losses.

### SUMMARY

In light of the above, a semiconductor device module according to claims 1, a method of manufacturing a semiconductor device module according to claim 6, semiconductor device module manufacturing device according to claim 15, and a semiconductor device module according to claim 18 are provided.

According to one embodiment, a semiconductor device module is provided, including a number of n semiconductor devices formed on a substrate, n being an integer ≥ 2; each semiconductor device having a stack of a first contact layer region, a semiconductor layer region, and a second contact layer region; wherein the first contact layer region of each (n-1)th semiconductor device is connected to the second contact layer region of the nth semiconductor device by an interconnection; and wherein, of the first and second contact layer regions, at least the first contact layer region of at least one of the semiconductor devices has a varying thickness, the thickness being maximum at the interconnection.

According to another embodiment, a method of manufacturing a semiconductor device module including a number of n semiconductor devices formed on a substrate, n being an integer ≥ 2, is provided, each semiconductor device having a stack of a first contact layer region, a semiconductor layer region, and a second contact layer region; the method including the steps of: forming a stack of a first contact layer, a semiconductor layer, and a second contact layer, which includes n stacks of a first contact layer region, a semiconductor layer region, and a second contact layer region, wherein the first contact layer region of each (n-1)th semiconductor device is connected to the second contact layer region of the nth semiconductor device by an interconnection; wherein, of the first and second contact layer regions, at least the first contact layer region of at least one of the semiconductor devices is formed with a varying thickness, the thickness being maximum at the interconnection.

According to a further embodiment, a semiconductor device module manufacturing device for manufacturing a semiconductor device module is provided, the semiconductor device module including a number of n semiconductor devices formed on a substrate, each semiconductor device having a stack of a first contact layer region, a semiconductor layer region, and a second contact layer region, wherein the first contact layer region of each (n-1)th semiconductor device is connected to the second contact layer region of the nth semiconductor device by an interconnection, n being an integer ≥ 2; the semiconductor device module manufacturing device including a contact layer thickness modulation device adapted to perform a step of forming at least one of the first and the second contact layer regions of at least one of the semiconductor devices with a varying thickness, the thickness being maximum at the interconnection.

A further embodiment provides a semiconductor device module obtainable by a method of manufacturing a semiconductor device module including a number of n semiconductor devices formed on a substrate, n being an integer ≥ 2, each semiconductor device having a stack of a first contact layer region, a semiconductor layer region, and a second contact layer region; the method including the steps of: forming a stack of a first contact layer, a semiconductor layer, and a second contact layer, which includes n stacks of a first contact layer region, a semiconductor layer region, and a second contact layer region, wherein the first contact layer region of each (n-1)th semiconductor device is connected to the second contact layer region of the nth semiconductor device by an interconnection; wherein, of the first and second contact layer regions, at least the first contact layer region of at least one of the semiconductor devices is formed with a varying thickness, the thickness being maximum at the interconnection.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. They may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Fig. 1 schematically illustrates part of a semiconductor device module formed by a method of manufacturing a semiconductor device;

Fig. 2 schematically illustrates a partial cross sectional illustration of a superstrate thin-film solar cell module;

Figs. 3a and 3b each schematically illustrate an intermediate product of a semiconductor device module formed by a method of manufacturing a semiconductor device according to embodiments;

Fig. 4 illustrates a final product of a semiconductor device module formed by a method of manufacturing a semiconductor device according to embodiments,

Fig. 5 schematically illustrates a final product of a semiconductor device module formed by another method of manufacturing a semiconductor device according to embodiments; and

Fig. 6 schematically illustrates a semiconductor device module manufacturing device according to embodiments.

It is contemplated that elements of one embodiment may be advantageously utilized in other embodiments without further recitation.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope, in the following the examples and embodiments of the method of manufacturing a semiconductor device module and of the semiconductor device module manufacturing device are described referring to the manufacture and interconnection of a thin-film solar cell module. Typical applications of embodiments described herein are for example in thin-film photovoltaic module manufacturing, in solar wafer manufacturing, in semiconductor device production and in the production of displays, such as LCD, TFT displays and OLED (Organic Light Emitting Diode).

Within the following description of the drawings, the same reference numbers refer to the same components. Generally, only the differences with respect to the individual embodiments are described.

As mentioned above, in a typical solar cell module including series-connected cell stripes, Ohmic losses are created in the contacts. Further, the current density within the contacts in a direction perpendicular to the cell stripes is varying. The Ohmic losses in the contacts are highest at highest current density and lowest at lowest current density. For example, in a superstrate type solar cell module, the main Ohmic loss may be produced in the front contacts and an increased thickness of the front contacts may promote transmission losses.

For instance, in a superstrate solar cell module having front contacts consisting of TCO, the main Ohmic loss is typically produced in the TCO material of the front contacts. The current and the current density per unit of length, also referred to herein as current density, within the TCO front contacts in a direction perpendicular to the cell stripes is highest near to the cell interconnection at the P2 pattern and is typically linearly decreasing to zero at the opposite end of the cell stripe, at which the front contact isolation formed by the P1 pattern is formed. Fig. 2 shows as an example a partial cross sectional illustration of a superstrate thin-film solar cell module including on the glass plate 1 a plurality of stacks of the front contact 2, the active silicon layer 3 and the back contact 4, the stacks forming solar cell stripes 7 each having a length 1. The width w of each solar cell or solar cell stripe 7, respectively, as shown in Fig. 2 corresponds to the distance between a left side face of the P3 isolation of one solar cell stripe and the left side face of the P3 isolation of the next solar cell stripe. That means, the width w represents a period w of a sequence of the solar cells. The formula shown in Fig. 2 represents a calculation of the Ohmic loss. The dotted line indicated in Fig. 2 illustrates the current path through the solar cells. The losses in the TCO front contacts 2 are highest at highest current density and lowest at lowest current density, following the formula power loss equal to I²R. The conductivity of the TCO may be increased by increasing the thickness of the TCO front contacts, i.e. the front contact dimension perpendicular to the semiconductor layer. However, in this case, the transmission losses within the TCO front contacts are also increased.

According to one embodiment, a semiconductor device module is provided, including a number of n semiconductor devices formed on a substrate, n being an integer ≥ 2; each semiconductor device having a stack of a first contact layer region, a semiconductor layer region, and a second contact layer region; wherein the first contact layer region of each (n-1)th semiconductor device is connected to the second contact layer region of the nth semiconductor device by an interconnection; and wherein, of the first and second contact layer regions, at least the first contact layer region of at least one of the semiconductor devices has a varying thickness, the thickness being maximum at the interconnection. In some embodiments, which can be combined with any other embodiment described herein, the interconnection may be formed near or at one end of the first contact layer region. In further embodiments, which can be combined with any other embodiment described herein, the thickness of at least the first contact layer region of at least one of the semiconductor devices is maximum at, adjacent and/or near to the interconnection. For instance, the thickness of the first contact layer region of at least one semiconductor device may be maximum throughout the part of the first contact layer region, which is not covered or is not to be covered by the semiconductor layer region of the at least one semiconductor device. Referring to Fig. 2 for an explanation, according to embodiments described herein, the thickness of the first contact layer region 2 of at least one semiconductor device may be maximum from the end of the first contact layer region 2, at which the interconnection is formed, up to, but substantially exclusive of, the position at which the width wₐ of the semiconductor layer region 3 begins.

Consequently, according to embodiments described herein, at least the first contact layer region of at least one of the semiconductor devices has a thickness which is highest at the position of the interconnection, i.e. at a position of high current density. Moreover, the thickness may be low at a position at which the current density is low. As a result, in the first contact layer, Ohmic losses are minimized and, at the same time, transmission may be maximized. In particular, in some embodiments, in which the semiconductor devices are solar cells, the first contact layer region of at least one of the semiconductor devices has a thickness which is highest at the position of the interconnection, i.e. at a position of high current density during light irradiation, and a thickness which may be low at a position or at positions at which the current density is low during light irradiation. Moreover, in some embodiments, in which the semiconductor devices are solar cells, e.g. of the superstrate type, the transmission through the first contact regions of the solar cells may be maximized in regions of low thickness.

According to some embodiments, which can be combined with any other embodiment described herein, the first contact layer includes a transparent material. In further embodiments, which can be combined with any other embodiment described herein, the thickness of the first contact layer is its dimension perpendicular to the semiconductor layer, and/or the thickness between the substrate and the semiconductor layer, respectively. In one embodiment, which can be combined with any other embodiment described herein, the first contact layer region is formed on the substrate, the semiconductor layer region is formed on the first contact layer region, and the second contact layer region is formed on the semiconductor layer region.

In some embodiments, which may be combined with any other embodiments described herein, the semiconductor devices are at least one element selected from the group consisting of solar cells, thin-film solar cells, thin-film solar cells of the substrate type, and thin-film solar cells of the superstrate type. In other embodiments, which may be combined with any other embodiments described herein, the substrate is a transparent substrate, the semiconductor layer region is an active layer of a solar cell, the first contact layer region is a front contact of a solar cell, and/or the second contact layer is a back contact of a solar cell. Further, the substrate may be formed from a transparent material. The substrate may for instance be a glass substrate. Furthermore, the substrate may be rigid or flexible, such as a rigid plate or a flexible web.

In some embodiments, which may be combined with any other embodiment described herein, the substrate may be a glass substrate and/or the semiconductor layer, also referred to herein as active layer, may be a silicon layer. Further, the first contact layer and/or the second contact layer may include or consist of a TCO. Moreover, the first contact layer may be a front contact layer and the second contact layer may be a back contact layer, e.g. corresponding to a superstrate structure.

According to a further embodiment, a method of manufacturing a semiconductor device module including a number of n semiconductor devices formed on a substrate, n being an integer ≥ 2, is provided, each semiconductor device having a stack of a first contact layer region, a semiconductor layer region, and a second contact layer region; the method including the steps of: forming a stack of a first contact layer, a semiconductor layer, and a second contact layer, which includes n stacks of a first contact layer region, a semiconductor layer region, and a second contact layer region, wherein the first contact layer region of each (n-1)th semiconductor device is connected to the second contact layer region of the nth semiconductor device by an interconnection; wherein, of the first and second contact layer regions, at least the first contact layer region of at least one of the semiconductor devices is formed with a varying thickness, the thickness being maximum at the interconnection.

In some embodiments, which can be combined with any other embodiment described herein, the first contact layer regions of neighboring semiconductor devices may be or may be formed isolated from each other. In further embodiments, which can be combined with any other embodiment described herein, the second contact layer regions of neighboring semiconductor devices may be or may be formed isolated from each other. In some embodiments, which can be combined with any other embodiment described herein, the semiconductor layer regions of neighboring semiconductor devices may be or may be formed isolated from each other.

In other embodiments, which may be combined with any other embodiment described herein, of the first and second contact layer regions, at least the first contact layer region of the at least one semiconductor device may have or may be formed with a thickness which is decreasing starting from the interconnection. In some embodiments, which can be combined with any other embodiment described herein, the thickness may decrease starting from the interconnection up to at least one end of the first contact layer region. In some embodiments, which can be combined with any other embodiment described herein, the interconnection may be formed near or at one end of the first contact layer region and the thickness may decrease up to an opposite end of the first contact layer region. Further, at least the first contact layer region have or may be formed with a thickness being at least one element selected from the group consisting of a linearly decreasing thickness and a stepwise decreasing thickness.

In further embodiments, at least one contact layer of the first and second contact layers is formed by at least one step selected from the group consisting of: forming the contact layer with a homogeneous thickness and partially removing the contact layer in the contact layer region; forming the contact layer with a homogeneous thickness and partially removing the contact layer in the contact layer region by etching and/or laser treatment; and forming the contact layer with a varying thickness by adapting the coating rate.

In some embodiments of the method of manufacturing a semiconductor device module, a sequence of the semiconductor devices having a period w, at least the first contact layer of the first and second contact layers may be formed with a recurrent thickness modulation having the period w. The period w may be in parallel to the semiconductor layer. For instance, at least the first contact layer region or a precursor of the first contact layer region of each semiconductor device has a dimension w in parallel to the semiconductor layer region, and at least the first contact layer is formed with a recurrent thickness modulation having a period w.

According to some embodiments, the method further includes forming the first contact layer regions by forming a number of n-1 first grooves in the first contact layer after the step of forming a first contact layer on the substrate, filling the first grooves with an insulating material or, during the step of forming the semiconductor layer, filling the first grooves with the semiconductor layer; forming the semiconductor layer regions before the step of forming the second contact layer by forming a number of n-1 second grooves in the semiconductor layer at the positions of the interconnections, the second grooves extending to the first contact layer; and forming the second contact layer regions by forming a number of n-1 third grooves in the second contact layer and the semiconductor layer.

According to some embodiments, which can be combined with any other embodiments described herein, at least one element selected from the group consisting of the interconnections, the first grooves and the second grooves are formed in parallel to each other.

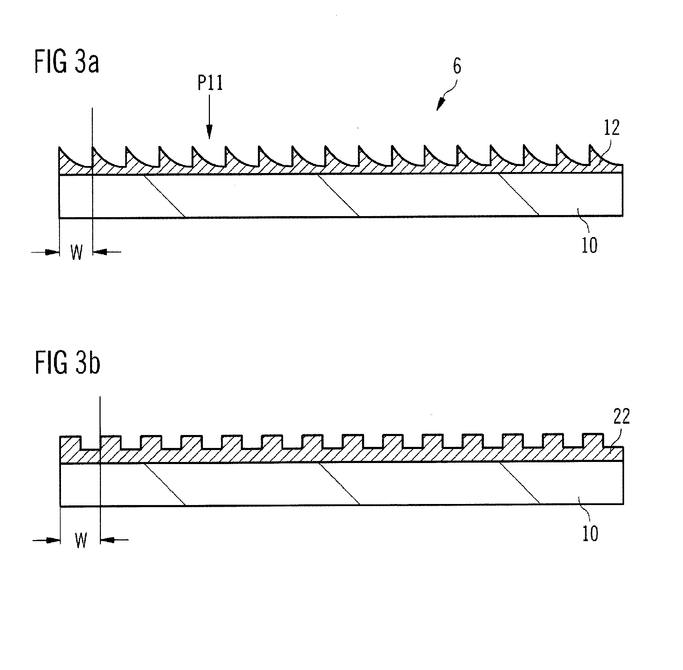

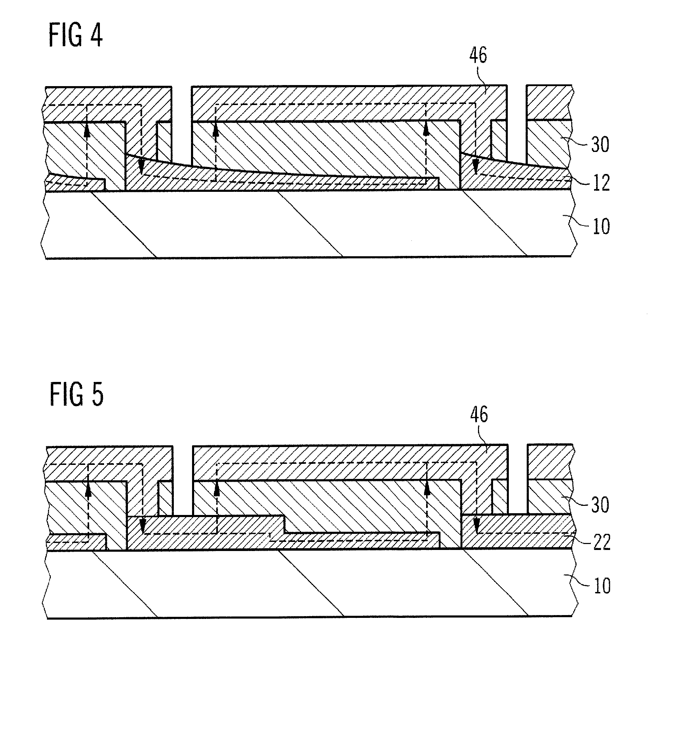

According to one example of embodiments, the interconnection scheme of a thin-film solar cell module having a solar cell, as shown for instance in Fig. 4, is formed by the following steps. Reference is made to Fig. 3a, showing an intermediate product of the present example. At first, a front contact layer 12 having a homogeneous thickness and consisting of TCO is deposited on a glass plate 10, which is the substrate. In a first laser step, the front contact layer 12 is patterned with a laser beam P11 from the back contact side 6, as illustrated in Fig. 3a. Settings, e.g. pulse, pulse modulation, beamforming, frequency, intensity and intensity grading, of the laser beam are used, which are adjusted for removal of the TCO material. In one example, during patterning, the laser is moved relatively to and across the TCO coated plate 10, in the present example from the left to the right of Fig. 3a. At the same time, the laser beam P11, e.g. its intensity, is modulated with a period w corresponding to the period w of the sequence of the solar cells to be formed. The modulation of the intensity is such that at the positions, at which in each period w of the solar cells the interconnection between the front contacts and the back contacts is to be formed, the intensity is minimal or even shut off. Subsequently, in each period w, the intensity of the laser is increased, in order to remove an increased portion of the TCO material of the front contact layer 12. In the present example, the intensity of the laser beam is linearly increased approaching a limit value. This results in a corrugated structure of the front contact layer 12. In the present example, the corrugated structure has steep flanks near the positions of the interconnections to be formed and has a small thickness of the front contact layer 12 adjacent to the steep flanks. The resulting front contact layer thickness 12 is maximal at the position of the interconnections to be formed. Thereby, the front contact regions, also referred to herein as front contacts, of the solar cells are provided.

Subsequently, steps of a deposition and patterning procedure of the silicon layer and the back contact layer such as described above referring to Fig. 1 and 2 may be performed, in order to complete the solar cell module manufacture. For instance, the front contact isolation formed by the P1 pattern is provided and an active silicon layer 30, formed of amorphous Si, is deposited on the front contact layer 12. The silicon layer 30 is patterned with the laser beam P2, e.g. from the back contact side 6. Thereby, the active silicon layer is opened for a subsequent interconnection of neighboring solar cells. Then, the back contact layer 40, which is in the present example formed of Cu, is deposited on the active silicon layer 30 and fills the P2 pattern. This results in the interconnection of the back contact of a solar cell to the front contact of a neighboring solar cell. Then, the back contact layer 40 is patterned together with the active layer 30 by laser beam P3, e.g. from the back contact side 6. Thereby, the back contacts of individual solar cells are isolated by forming grooves 45 in the back contact layer 40 and the active layer 30. Such a process results in a solar cell module deposited on the glass plate, having a corrugated front contact layer, and cut into cell stripes, which are serially connected to each other by a plurality of interconnections, as illustrated in Fig. 4. In addition, the corrugated structure of the front contact layer 12 and the P1 pattern provides a current path, by which the front contacts of neighboring solar cells are effectively isolated from each other.

In a modification of above example of embodiments, after deposition of the front contact layer 12, for patterning thereof, in each period w the intensity of the laser is increased, in order to remove an increased portion of the TCO material of the front contact layer 12, resulting in a corrugated structure of the front contact layer 12 having steep flanks near the positions of the interconnections to be formed. According to the present modification of above example, the intensity of the laser beam may be linearly increased such that the thickness of the front contact layer 12 approaches zero adjacent to the steep flanks of the corrugated structure.

In above modification of an example of embodiments, after providing the corrugated structure of the front contact layer 12, the front contact layer 12 may be patterned with a laser beam, such as described above referring to Fig. 1 using laser beam P1. Thereby, the front contacts of the solar cells are isolated by grooves, e.g. by grooves adjacent to the steep flanks of the corrugated structure shown in Fig. 3a. The grooves can be filled with an electrically isolating material or can be filled with silicon in the subsequent step of deposition the active silicon layer 30, resulting in the final solar cell module.

In some embodiments described herein, the method may be adapted to form a solar cell module including only one solar cell or some solar cells having a front contact with a varying thickness, the thickness being maximal at the interconnection to a neighboring solar cell. In such a case, in the first laser step, the laser beam P11, e.g. its intensity, is modulated as described above just in one or some, respectively, periods w of the sequence of the solar cells to be formed.

In other embodiments, which can be combined with any other embodiment described herein, the first contact layer may be a layer or layer stack in which at least one of the layers includes at least one element selected from the group consisting of TCO and a metal, such as Cu or Ag. Moreover, in some embodiments, which can be combined with any other embodiment described herein, the semiconductor layer may be a layer or layer stack in which at least one of the layers includes at least one element selected from the group consisting of amorphous Si (a-Si), microcrystalline Si (µc-Si), and an a-Si/µc-Si-tandem stack. In other embodiments, which can be combined with any other embodiment described herein, the second contact layer may be a layer or layer stack in which at least one of the layers includes at least one element selected from the group consisting of TCO and a metal, such as Cu or Ag.

In some embodiments, at least one layer selected from the first contact layer and the second contact layer includes a transparent conductive oxide. Examples of TCO are ITO (Indium Tin Oxide), ZnO, and SnO. According to embodiments, which can be combined with any other embodiment described herein, the TCO may have a minimal thickness of about 10 to 15 nm and/or the solar cell may have a thickness of about 1 µm and a width w of about 100 µm to about 300 µm.

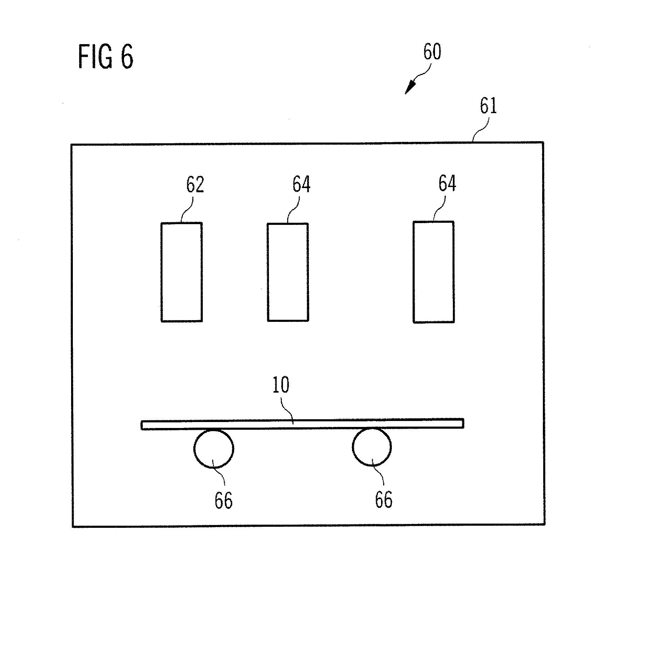

According to another example of embodiments, the interconnection scheme of a thin-film solar cell module having a solar cell, as shown for instance in Fig. 5, is formed by the following steps. Reference is made to an intermediate product of the solar cell module shown in Fig. 3b and the semiconductor device module manufacturing device illustrated in Fig. 6. At first, a front contact layer 22 having a varying thickness and consisting of TCO is deposited on a glass plate 10 using a coating device 64. The varying thickness of the front contact layer 22 is achieved by controlling the coating rate of the coating device, while the TCO coated plate 10 is moving below the coating device, in the present example from the right to the left of Fig. 6. The coating rate is modulated using a period w, which corresponds to the period w of the sequence of the solar cells to be formed. The modulation period has a first and a second interval corresponding to a first half and a second half of the period w. During the first interval, the coating rate is set high enough, e.g. maximal, for depositing the maximum contact layer thickness. Thereby, in one half of each period w of the solar cells, in which the interconnection between the front contacts and the back contacts is to be formed, the maximum front contact layer thickness is provided. Subsequently, in the second interval of each period w, the coating rate of the coating device is adjusted to a half of the coating rate of the first interval, in order to provide half of the maximum front contact layer thickness. Consequently, a stepped structure of the front contact layer 22 having maximum thickness near the positions of the interconnections is formed, as shown in Fig. 3b. Hence, the resulting front contact layer thickness 12 is maximal at the position of the interconnections to be formed. Thereby, individual front contact regions, also referred to herein as front contacts, of the solar cells are provided, which each have two steps. Subsequently, steps of a deposition and patterning procedure of the silicon layer and the back contact layer such as described above referring to Fig. 1 and 2 may be performed, in order to complete the solar cell module manufacture. As a result, the stepped structure of the front contact layer 22 and e.g. the P1 pattern provides a current path, by which the front contacts of neighboring solar cells are effectively isolated from each other.

According to a variation of above example of embodiments, the first and the second interval of the coating rate modulation period of the coating device may not correspond to the first half and the second half of the solar cell sequence period w, respectively. For instance, the first interval may correspond to a quarter of the period w, while the second interval corresponds to three quarters of the period w. Thereby, a stepped structure of the front contact layer 22 results, wherein the steps at the interconnections to be formed have the maximal thickness, but a small extension in parallel to the plate 10. Furthermore, in some variations of embodiments, the coating rates in the second interval of period w may be adjusted to more or less than a half of the coating rate used in the first interval. In a further modification of embodiments, more than one step may be provided in one or more periods w of the semiconductor device module.

According to one example of embodiments, after providing the stepped structure of the front contact layer 22, the front contact layer 22 may be patterned with a laser beam, such as described above referring to Fig. 1 using laser beam P1, e.g. provided by laser device 62 shown in Fig. 6. Thereby, the front contacts of the solar cells are isolated by grooves, e.g. adjacent to the steep flanks of the stepped structure. The grooves can be filled with an electrically isolating material or can be filled with silicon in the subsequent step of deposition the active silicon layer 30, resulting in a final solar cell module as shown in Fig. 5.

Embodiments described herein provide for a semiconductor device module, in which at least the first contact layer region of at least one of the semiconductor devices has a thickness which is highest at the position of the interconnection, i.e. at a position or at positions of high current density. Moreover, the thickness may be low at a position or at positions, at which the current density is low. As a result, at least in the first contact layer, Ohmic losses are minimized. At the same time, the transmission of at least the first contact layer may be maximized, since it includes sections having a small thickness. In particular, in some embodiments, in which the semiconductor devices are solar cells, the first contact layer region of at least one of the semiconductor devices has a thickness which is highest at the position of the interconnection, i.e. at a position of high current density during light irradiation, and a thickness which may be low at a position or at positions at which the current density is low during light irradiation. Moreover, in some embodiments, in which the semiconductor devices are solar cells, e.g. of the superstrate type, the transmission through the first contact regions of the solar cells may be maximized in regions of low thickness. According to some embodiments, a module of thin-film solar cells having a superstrate structure may be provided, in which the first contact layer is a front contact layer formed of TCO and has a regular modulation in each cell. Embodiments described herein allow for providing a thickness of a transparent front contact, e.g. including a TCO, of a solar cell, which is high or highest at the position of high current density and lowest at the position of low current density, in order to maximize the front contact transmission and minimize Ohmic loss simultaneously. This can be achieved either by producing the front contact layer with initially the targeted varying thickness or by removing part of the front contact material from an initially homogeneous front contact film. The thickness of the front contact may follow a regular modulation with the cell width as cycle period. Examples for creating a thickness modulation of the front contact are modulation of the process parameters during front contact coating in an in-line manufacturing device and/or removal of the front contact material by etching or laser scribing.

According to other embodiments, a semiconductor device module manufacturing device for manufacturing a semiconductor device module is provided, the semiconductor device module including a number of n semiconductor devices formed on a substrate, each semiconductor device having a stack of a first contact layer region, a semiconductor layer region, and a second contact layer region, wherein the first contact layer region of each (n-1)th semiconductor device is connected to the second contact layer region of the nth semiconductor device by an interconnection, n being an integer ≥ 2;the semiconductor device module manufacturing device including a contact layer thickness modulation device adapted to perform a step of forming at least one of the first and the second contact layer regions of at least one of the semiconductor devices with a varying thickness between the substrate and the semiconductor layer, the thickness being maximum at the interconnection. The contact layer thickness modulation device may be adapted to perform a method according to any of above embodiments.

In some embodiments, the contact layer thickness modulation device includes at least one device selected from the device group consisting of a contact layer coating device, a contact layer removing device, a contact layer coating device including a coating rate control device, and a contact layer removing device including at least one element selected from the group consisting of a contact layer etching device and a laser device; and/or wherein the semiconductor device module manufacturing device includes a control device adapted to control the contact layer thickness modulation device such that at least one of a first contact layer and a second contact layer is formed with a recurrent thickness modulation having the period w in parallel to the semiconductor layer.

According to other embodiments, the first contact layer region of each semiconductor device has a dimension w in parallel to the semiconductor layer region, and the first contact layer thickness modulation device is adapted to perform at least one of the steps selected from the group consisting of forming the first contact layer with a recurrent thickness modulation having a period w; forming the first contact layer with a recurrent thickness modulation having a period w and forming in each period w the first contact layer with a thickness which is decreasing starting from the interconnection; and forming the first contact layer with a recurrent thickness modulation having a period w and forming in each dimension w the first contact layer

As an example, a semiconductor device module manufacturing device 60 according to embodiments is schematically shown in Fig. 6. The semiconductor device module manufacturing device 60 includes a housing 61, which may be a vacuum chamber. In the housing 61 one or more coating devices 64, a laser device 62 and a transport system, e.g. including transport rolls 66 for conveying the substrate 10, are provided. As shown in Fig. 6, on the transport rolls 66, the substrate 10, e.g. coated with a front contact layer (not shown), may be transported below the coating devices 64 and the laser device 62 from the right to the left. According to one example, the laser device 62 may provide the laser beam P11 of the method describe referring to Fig. 3a and Fig. 4. According to another example, one of the coating devices 64 may be used for deposition of the front contact layer 22, as described referring to Figs. 3b and 5.

According to one embodiment, a semiconductor device module is provided, including a number of n semiconductor devices formed on a substrate, n being an integer ≥ 2; each semiconductor device having a stack of a first contact layer region, a semiconductor layer region, and a second contact layer region; wherein the first contact layer region of each (n-1)th semiconductor device is connected to the second contact layer region of the nth semiconductor device by an interconnection; and wherein, of the first and second contact layer regions, at least the first contact layer region of at least one of the semiconductor devices has a varying thickness, the thickness being maximum at the interconnection.

In one embodiment, which may be combined with any other embodiment described herein, of the first and second contact layer regions, the thickness of at least the first contact layer region of the at least one semiconductor device is decreasing starting from the interconnection.

In one embodiment, which may be combined with any other embodiment described herein, of the first and second contact layer regions, at least the first contact layer region of the at least one semiconductor device is formed with a thickness being at least one element selected from the group consisting of a linearly decreasing thickness and a stepwise decreasing thickness.

In one embodiment, which may be combined with any other embodiment described herein, the semiconductor devices are at least one element selected from the group consisting of solar cells, thin-film solar cells, thin-film solar cells of the substrate type, and thin-film solar cells of the superstrate type.

In one embodiment, which may be combined with any other embodiment described herein, one or more semiconductor devices includes at least one element selected from the group consisting of the substrate being a transparent substrate, the semiconductor layer region being an active layer of a solar cell, the first contact layer region being a transparent contact, the first contact layer region being a front contact of a solar cell, and the second contact layer being a back contact of a solar cell.

In one embodiment, which may be combined with any other embodiment described herein, the semiconductor devices are formed as cell stripes connected by n-1 interconnections, and at least one element selected from the group consisting of the cell stripes and the interconnections are formed in parallel to each other.

In one embodiment, which may be combined with any other embodiment described herein, at least one element selected from the first contact layer regions and the second contact layer region includes a transparent conductive oxide.

In one embodiment, which may be combined with any other embodiment described herein, the semiconductor layer includes Si.

According to another embodiment, a method of manufacturing a semiconductor device module including a number of n semiconductor devices formed on a substrate, n being an integer ≥ 2, is provided, each semiconductor device having a stack of a first contact layer region, a semiconductor layer region, and a second contact layer region; the method including the steps of: forming a stack of a first contact layer, a semiconductor layer, and a second contact layer, which includes n stacks of a first contact layer region, a semiconductor layer region, and a second contact layer region, wherein the first contact layer region of each (n-1)th semiconductor device is connected to the second contact layer region of the nth semiconductor device by an interconnection; wherein, of the first and second contact layer regions, at least the first contact layer region of at least one of the semiconductor devices is formed with a varying thickness, the thickness being maximum at the interconnection.

In one embodiment, which may be combined with any other embodiment described herein, of the first and second contact layer regions, at least the first contact layer region of the at least one semiconductor device is formed with a thickness which is decreasing starting from the interconnection.

In one embodiment, which may be combined with any other embodiment described herein, of the first and second contact layer regions, at least the first contact layer region of the at least one semiconductor device is formed with a thickness being at least one element selected from the group consisting of a linearly decreasing thickness and a stepwise decreasing thickness.

In one embodiment, which may be combined with any other embodiment described herein, of the first and second contact layers, at least one contact layer is formed by at least one step selected from the group consisting of: forming the contact layer with a homogeneous thickness and partially removing the contact layer in the contact layer region; forming the contact layer with a homogeneous thickness and partially removing the contact layer in the contact layer region by at least one step selected from the group consisting of etching and laser treatment; and forming the contact layer with a varying thickness by adapting the coating rate.

In one embodiment, which may be combined with any other embodiment described herein, a sequence of the semiconductor devices has a period w, and wherein, of the first and second contact layers, at least the first contact layer is formed with a recurrent thickness modulation having the period w.

In one embodiment, which may be combined with any other embodiment described herein, of the first and second contact layers, at least one contact layer is formed by at least one step selected from the group consisting of: forming in each period w the contact layer with a thickness which is decreasing starting from the interconnection; and forming in each period w the contact layer with a thickness selected from the group consisting of a linearly decreasing thickness and a stepwise decreasing thickness.

In one embodiment, which may be combined with any other embodiment described herein, the method further includes at least one step selected from the group consisting of: forming the first contact layer regions by forming a number of n-1 first grooves in the first contact layer after the step of forming a first contact layer on the substrate, filling the first grooves with an insulating material or, during the step of forming the semiconductor layer, filling the first grooves with the semiconductor layer; forming the semiconductor layer regions before the step of forming the second contact layer by forming a number of n-1 second grooves in the semiconductor layer at the positions of the interconnections, the second grooves extending to the first contact layer; and forming the second contact layer regions by forming a number of n-1 third grooves in the second contact layer and the semiconductor layer.

In one embodiment, which may be combined with any other embodiment described herein, at least one element selected from the group consisting of the interconnections, the first grooves, the second grooves and the third grooves are formed in parallel to each other.

In one embodiment, which may be combined with any other embodiment described herein, at least one layer selected from the first contact layer and the second contact layer includes a transparent conductive oxide.

In one embodiment, which may be combined with any other embodiment described herein, the semiconductor layer includes Si.

According to a further embodiment, a semiconductor device module manufacturing device for manufacturing a semiconductor device module is provided, the semiconductor device module including a number of n semiconductor devices formed on a substrate, each semiconductor device having a stack of a first contact layer region, a semiconductor layer region, and a second contact layer region, wherein the first contact layer region of each (n-1)th semiconductor device is connected to the second contact layer region of the nth semiconductor device by an interconnection, n being an integer ≥ 2; the semiconductor device module manufacturing device including a contact layer thickness modulation device adapted to perform a step of forming at least one of the first and the second contact layer regions of at least one of the semiconductor devices with a varying thickness, the thickness being maximum at the interconnection.

In one embodiment, which may be combined with any other embodiment described herein, in the semiconductor module a sequence of the semiconductor devices has a period w, and wherein the contact layer thickness modulation device includes: at least one device selected from the device group consisting of a contact layer coating device, a contact layer removing device, a contact layer coating device including a coating rate control device, and a contact layer removing device including at least one element selected from the group consisting of a contact layer etching device and a laser device.

In one embodiment, which may be combined with any other embodiment described herein, the semiconductor device module manufacturing device includes a control device adapted to control the contact layer thickness modulation device such that at least one of a first contact layer and a second contact layer is formed with a recurrent thickness modulation having the period w in parallel to the semiconductor layer.

In one embodiment, which may be combined with any other embodiment described herein, the first contact layer region of each semiconductor device has a dimension w in parallel to the semiconductor layer region, and wherein the first contact layer thickness modulation device is adapted to perform at least one of the steps selected from the group consisting of forming the first contact layer with a recurrent thickness modulation having a period w; forming the first contact layer with a recurrent thickness modulation having a period w and forming in each period w the first contact layer with a thickness which is decreasing starting from the interconnection; and forming the first contact layer with a recurrent thickness modulation having a period w and forming in each dimension w the first contact layer with a thickness which is linearly and/or stepwise decreasing departing from the interconnection.

A further embodiment provides a semiconductor device module obtainable by a method of manufacturing a semiconductor device module including a number of n semiconductor devices formed on a substrate, n being an integer ≥ 2, each semiconductor device having a stack of a first contact layer region, a semiconductor layer region, and a second contact layer region; the method including the steps of: forming a stack of a first contact layer, a semiconductor layer, and a second contact layer, which includes n stacks of a first contact layer region, a semiconductor layer region, and a second contact layer region, wherein the first contact layer region of each (n-1)th semiconductor device is connected to the second contact layer region of the nth semiconductor device by an interconnection; wherein, of the first and second contact layer regions, at least the first contact layer region of at least one of the semiconductor devices is formed with a varying thickness, the thickness being maximum at the interconnection.

One embodiment provides a semiconductor device module obtainable or obtained by any of above described embodiments of a method of manufacturing a semiconductor device module.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A semiconductor device module comprising a number of n semiconductor devices formed on a substrate (10), n being an integer ≥ 2; each semiconductor device having a stack of a first contact layer region (12; 22), a semiconductor layer region (30), and a second contact layer region (40);
wherein the first contact layer region of each (n-1)th semiconductor device is connected to the second contact layer region of the nth semiconductor device by an interconnection (46); and
wherein, of the first and second contact layer regions, at least the first contact layer region of at least one of the semiconductor devices has a varying thickness, the thickness being maximum at the interconnection.

2. The module according to claim 1, wherein, of the first and second contact layer regions, the thickness of at least the first contact layer region of the at least one semiconductor device is decreasing starting from the interconnection; and/or
wherein, of the first and second contact layer regions, at least the first contact layer region of the at least one semiconductor device is formed with a thickness being at least one element selected from the group consisting of a linearly decreasing thickness and a stepwise decreasing thickness.

3. The module according to any of the preceding claims, wherein the semiconductor devices are at least one element selected from the group consisting of solar cells, thin-film solar cells, thin-film solar cells of the substrate type, and thin-film solar cells of the superstrate type; and/or wherein one or more semiconductor devices comprises at least one element selected from the group consisting of the substrate being a transparent substrate, the semiconductor layer region being an active layer of a solar cell, the first contact layer region being a transparent contact, the first contact layer region being a front contact of a solar cell, and the second contact layer being a back contact of a solar cell.

4. The module according to any of the preceding claims, wherein the semiconductor devices are formed as cell stripes connected by n-1 interconnections, and at least one element selected from the group consisting of the cell stripes and the interconnections are formed in parallel to each other.

5. The module according to any of the preceding claims, wherein at least one element selected from the first contact layer regions and the second contact layer region includes a transparent conductive oxide, and/or wherein the semiconductor layer includes Si.

6. A method of manufacturing a semiconductor device module including a number of n semiconductor devices formed on a substrate (10), n being an integer ≥ 2, each semiconductor device having a stack of a first contact layer region (12; 22), a semiconductor layer region (30), and a second contact layer region (40);
the method comprising the steps of:
forming a stack of a first contact layer, a semiconductor layer, and a second contact layer, which includes n stacks of a first contact layer region, a semiconductor layer region, and a second contact layer region,
wherein the first contact layer region of each (n-1)th semiconductor device is connected to the second contact layer region of the nth semiconductor device by an interconnection (46);
wherein, of the first and second contact layer regions, at least the first contact layer region of at least one of the semiconductor devices is formed with a varying thickness, the thickness being maximum at the interconnection.

7. The method according to claim 6, wherein, of the first and second contact layer regions, at least the first contact layer region of the at least one semiconductor device is formed with a thickness which is decreasing starting from the interconnection; and/or
wherein, of the first and second contact layer regions, at least the first contact layer region of the at least one semiconductor device is formed with a thickness being at least one element selected from the group consisting of a linearly decreasing thickness and a stepwise decreasing thickness.

8. The method according to any of claims 6 or 7, wherein, of the first and second contact layers, at least one contact layer is formed by at least one step selected from the group consisting of:
forming the contact layer with a homogeneous thickness and partially removing the contact layer in the contact layer region;
forming the contact layer with a homogeneous thickness and partially removing the contact layer in the contact layer region by etching and/or laser treatment; and
forming the contact layer with a varying thickness by adapting the coating rate.

9. The method according to any of claims 6 to 8, wherein a sequence of the semiconductor devices has a period w, and
wherein, of the first and second contact layers, at least the first contact layer is formed with a recurrent thickness modulation having the period w.

10. The method according to claim 9, wherein, of the first and second contact layers, at least one contact layer is formed by at least one step selected from the group consisting of:
forming in each period w the contact layer with a thickness which is decreasing starting from the interconnection; and
forming in each period w the contact layer with a thickness selected from the group consisting of a linearly decreasing thickness and a stepwise decreasing thickness.

11. The method according to any of claims 6 to 10, wherein the semiconductor devices are at least one element selected from the group consisting of solar cells, thin-film solar cells, thin-film solar cells of the substrate type, and thin-film solar cells of the superstrate type,
and/or
wherein one or more semiconductor devices comprises at least one element selected from the group consisting of the substrate being a transparent substrate, the semiconductor layer region being an active layer of a solar cell, the first contact layer region being a transparent contact, the first contact layer region being a front contact of a solar cell, and the second contact layer being a back contact of a solar cell.

12. The method according to any of claims 6 to 11, further comprising at least one step selected from the group consisting of:
forming the first contact layer regions by forming a number of n-1 first grooves in the first contact layer after the step of forming a first contact layer on the substrate, filling the first grooves with an insulating material or, during the step of forming the semiconductor layer, filling the first grooves with the semiconductor layer;
forming the semiconductor layer regions before the step of forming the second contact layer by forming a number of n-1 second grooves in the semiconductor layer at the positions of the interconnections, the second grooves extending to the first contact layer; and
forming the second contact layer regions by forming a number of n-1 third grooves in the second contact layer and the semiconductor layer.

13. The method according to any of claims 6 to 12, wherein at least one element selected from the group consisting of the interconnections, the first grooves, the second grooves and the third grooves are formed in parallel to each other.

14. The method according to any of claims 6 to 13, wherein at least one layer selected from the first contact layer and the second contact layer includes a transparent conductive oxide, and/or wherein the semiconductor layer includes Si.

15. A semiconductor device module manufacturing device for manufacturing a semiconductor device module,
the semiconductor device module comprising a number of n semiconductor devices formed on a substrate, each semiconductor device having a stack of a first contact layer region, a semiconductor layer region, and a second contact layer region, wherein the first contact layer region of each (n-1)th semiconductor device is connected to the second contact layer region of the nth semiconductor device by an interconnection, n being an integer ≥ 2;
the semiconductor device module manufacturing device comprising a contact layer thickness modulation device (62; 64) adapted to perform a step of forming at least one of the first and the second contact layer regions of at least one of the semiconductor devices with a varying thickness, the thickness being maximum at the interconnection.

16. The device of claim 15, wherein the contact layer thickness modulation device is adapted to perform a method according to any of claims 6 to 14.

17. The device of claim 15 or 16,
wherein in the semiconductor module a sequence of the semiconductor devices has a period w, and
wherein the contact layer thickness modulation device comprises:
at least one device selected from the device group consisting of a contact layer coating device (64), a contact layer removing device (62), a contact layer coating device comprising a coating rate control device, and a contact layer removing device comprising at least one element selected from the group consisting of a contact layer etching device and a laser device (62); and/or
wherein the semiconductor device module manufacturing device comprises a control device adapted to control the contact layer thickness modulation device such that at least one of a first contact layer and a second contact layer is formed with a recurrent thickness modulation having the period w in parallel to the semiconductor layer.

18. A semiconductor device module obtainable by a method according to any of claims 6 to 14.
